# EUROPEAN PATENT APPLICATION

(11) **EP 4 187 587 A1**
(43) Date of publication of application: **31.05.2023**
(21) Application number: 21845635.8
(22) Date of filing: 16.07.2021
(51) Int. Cl.: H01L 23/13, H01L 23/12, H01L 23/36, H01L 25/07, H01L 25/18, H05K 1/02, H05K 1/03, H05K 3/10

(54) **CIRCUIT BOARD, AND METHOD FOR PRODUCING CIRCUIT BOARD**

(30) Priority: 22.07.2020 JP 2020124926
(71) Applicant: Kyocera Corporation, Kyoto-shi Kyoto 612-8501 (JP)
(72) Inventor: ABE, Yuichi, Kyoto-shi, Kyoto 612-8501 (JP)
(74) Representative: Viering, Jentschura & Partner mbB Patent- und Rechtsanwälte
(86) International application number: PCT/JP2021/026873
(87) International publication number: WO 2022/019242

(57) **Abstract**

A circuit board (1) includes a ceramic substrate (2) having a flat plate shape and a metal plate (3) bonded to one main surface of the ceramic substrate (2) and including a predetermined circuit pattern. An outer peripheral surface (3c) of the metal plate (3) includes a protruding portion (11) protruding outward and a pair of recessed surfaces (12) provided at both sides of the protruding portion (11).

## Description

### TECHNICAL FIELD

An embodiment of the disclosure relates to a circuit board and a manufacturing method for a circuit board.

### BACKGROUND OF INVENTION

Examples of a known circuit board used for an electronic device in which an electronic component such as a power semiconductor element is mounted include a circuit board in which a metal plate including a circuit pattern is bonded to a main surface of a ceramic substrate (see, for example, Patent Document 1).

### CITATION LIST

### PATENT LITERATURE

Patent Document 1: JP 2001-332854 A

### SUMMARY

### PROBLEM TO BE SOLVED

However, the known art has room for further enhancement in terms of improving reliability of the electronic device.

In light of the foregoing, an object of an aspect of the embodiment is to provide a circuit board that can provide improved reliability of an electronic device, and a manufacturing method for the circuit board.

### SOLUTION TO PROBLEM

In an aspect of an embodiment, a circuit board includes a ceramic substrate having a flat plate shape and a metal plate bonded to one main surface of the ceramic substrate and including a predetermined circuit pattern. An outer peripheral surface of the metal plate includes a protruding portion protruding outward and a pair of recessed surfaces provided at both sides of the protruding portion.

### BRIEF DESCRIPTION OF THE DRAWINGS

FIG. 1 is a perspective view illustrating an overall configuration of a circuit board according to an embodiment.
FIG. 2 is an arrow cross-sectional view taken along an A-A line illustrated in FIG. 1.
FIG. 3 is an enlarged cross-sectional view illustrating a configuration of the circuit board according to the embodiment.
FIG. 4 is an enlarged cross-sectional view illustrating a configuration of a circuit board according to a first variation of the embodiment.
FIG. 5 is an enlarged cross-sectional view illustrating a configuration of a circuit board according to a second variation of the embodiment.
FIG. 6 is an enlarged cross-sectional view illustrating a configuration of a circuit board according to a third variation of the embodiment.
FIG. 7 is an enlarged cross-sectional view illustrating a configuration of a circuit board according to a fourth variation of the embodiment.
FIG. 8 is an enlarged cross-sectional view illustrating a configuration of a circuit board according to a fifth variation of the embodiment.
FIG. 9 is an enlarged cross-sectional view illustrating a configuration of a circuit board according to a sixth variation of the embodiment.
FIG. 10 is an enlarged cross-sectional view illustrating a configuration of a circuit board according to a seventh variation of the embodiment.
FIG. 11 is an enlarged cross-sectional view illustrating a configuration of a circuit board according to an eighth variation of the embodiment.
FIG. 12 is an enlarged cross-sectional view illustrating a configuration of a circuit board according to a ninth variation of the embodiment.
FIG. 13 is a flowchart illustrating a procedure of a manufacturing process for a circuit board according to the embodiment.
FIG. 14 is a flowchart illustrating a procedure of a manufacturing process for the circuit board according to the eighth variation of the embodiment.

### DESCRIPTION OF EMBODIMENTS

Hereinafter, an embodiment of a circuit board and a manufacturing method for a circuit board that are disclosed in the present application will be described with reference to the accompanying drawings. The present invention is not limited by the following embodiment.

Examples of a known circuit board used for an electronic device in which an electronic component such as a power semiconductor element is mounted include a circuit board in which a metal plate including a circuit pattern is bonded to a main surface of a ceramic substrate.

However, the known art has room for further enhancement in terms of improving reliability of the electronic device. For example, the known art may cause dielectric breakdown of the ceramic substrate when electric field is concentrated at the outer peripheral portion of the metal plate applied with a high voltage.

The achievement of a technique that can overcome the aforementioned problem and improve reliability of an electronic device is awaited.

### Overall Configuration of Circuit Board

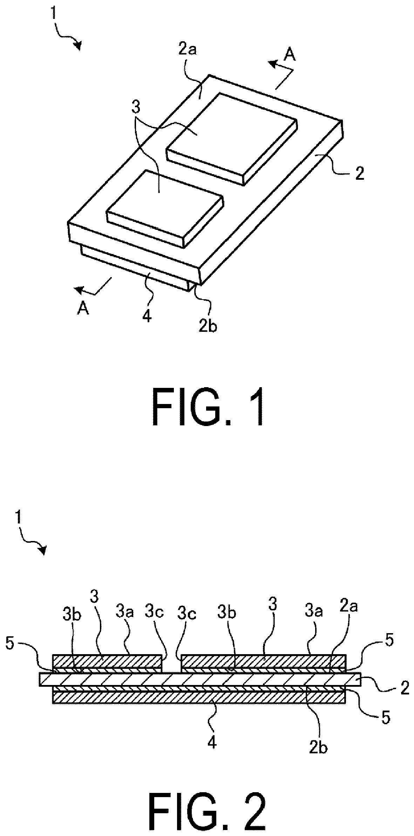

First, an overall configuration of a circuit board 1 according to the embodiment will be described with reference to FIG. 1 and FIG. 2. FIG. 1 is a perspective view illustrating the overall configuration of the circuit board 1 according to the embodiment, and FIG. 2 is an arrow cross-sectional view taken along an A-A line illustrated in FIG. 1.

As illustrated in FIG. 1, the circuit board 1 according to the embodiment includes a ceramic substrate 2, metal plates 3, and a metal plate 4. The circuit board 1 has a structure in which the metal plates 3, the ceramic substrate 2, and the metal plate 4 are layered in this order.

The ceramic substrate 2 has, for example, a rectangular flat plate shape in a plan view, and includes a front surface 2a that is one main surface and a back surface 2b that is the other main surface. However, in the present disclosure, the ceramic substrate 2 is not limited to a rectangular shape in a plan view.

Examples of ceramics configuring the ceramic substrate 2 suitably include, for example, alumina, silica, mullite, cordierite, forsterite, aluminum nitride, silicon nitride, silicon carbide, or glass ceramics. The ceramic substrate 2 preferably contains silicon nitride (Si₃N₄) as a main component in terms of its high coefficient of thermal conductivity.

Here, the terms "containing silicon nitride as a main component" mean that the ceramic substrate 2 contains 70 mass% or more of silicon nitride. When the silicon nitride contained in the ceramic substrate 2 is equal to or greater than 70 mass%, the coefficient of thermal conductivity of the ceramic substrate 2 is increased. Thus, a heat dissipation property of the circuit board 1 can be improved.

The ceramic substrate 2 has a thickness of, for example, about from 0.1 mm to 1 mm, and is appropriately set in accordance with conditions such as predetermined external dimensions and mechanical strength of an electronic device (not illustrated) in which the circuit board 1 is mounted.

The metal plate 3 is bonded to the front surface 2a of the ceramic substrate 2, and includes a predetermined circuit pattern. The terms "a predetermined circuit pattern" indicate a pattern shape corresponding to an electric circuit configured in an electronic device in which the circuit board 1 is mounted.

As illustrated in FIG. 2, the metal plate 3 includes a mounting surface 3a that is one main surface, a bonding surface 3b that is the other main surface, and an outer peripheral surface 3c. The mounting surface 3a is a surface on which electronic components (not illustrated) are mounted, and the bonding surface 3b is a surface bonded to the front surface 2a of the ceramic substrate 2 with a brazing material 5 interposed therebetween.

Examples of metal configuring the metal plate 3 suitably include metal containing copper, silver, aluminum as a main component. The metal plate 3 preferably contains copper as a main component in terms of high electric conductivity and a high coefficient of thermal conductivity.

Here, the terms "containing copper as a main component" mean that the metal plate 3 contains 70 mass% or more of copper. When the copper contained in the metal plate 3 is equal to or greater than 70 mass%, an allowable current that can flow through the electronic components mounted on the circuit board 1 can be increased.

The metal plate 4 is bonded to the back surface 2b of the ceramic substrate 2 with a brazing material 5 interposed therebetween. The metal plate 4 has, for example, a rectangular shape slightly smaller than the ceramic substrate 2 in a plan view. The metal same as, and/or similar to that of the metal plate 3 can be used for the metal plate 4. Note that the shapes of the metal plate 3 and the metal plate 4 are not limited to the examples of FIG. 1 and FIG. 2.

The thicknesses of the metal plate 3 and the metal plate 4 are, for example, about from 0.3 mm to 1 mm, and are appropriately set in accordance with conditions such as the predetermined external dimensions and the mechanical strength of the electronic device in which the circuit board 1 is mounted.

The brazing material 5 is made of, for example, a silver-copper-based or copper-based brazing material. The brazing material 5 preferably contains at least one active metal selected from the group consisting of titanium, hafnium, and zirconium. This improves the wettability with respect to the ceramic substrate 2, so that the metal plates 3 and 4 can be firmly bonded to the ceramic substrate 2.

The brazing material 5 preferably contains at least one type of high melting point metal selected from the group consisting of molybdenum, tungsten, tantalum, and osmium. This can improve shape retainability of the brazing material 5, avoid spread of the brazing material 5 to the surface of the ceramic substrate 2, and improve insulation.

The brazing material 5 may contain at least one type of a metal material selected from the group consisting of indium and tin. This can lower a melting point of the silver-copper-based brazing material, so that residual stress due to thermal stress generated upon manufacturing the circuit board 1 can be reduced. A thickness of the brazing material 5 is, for example, approximately from 5 µm to 100 µm.

### Embodiment

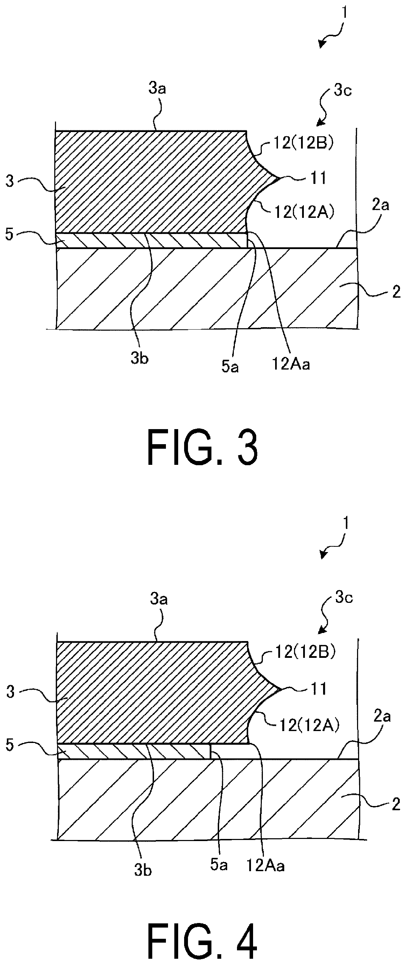

Details of the configuration of the circuit board 1 according to the embodiment will be described with reference to FIG. 3. FIG. 3 is an enlarged cross-sectional view illustrating a configuration of the circuit board 1 according to the embodiment, and is an enlarged cross-sectional view of the outer peripheral surface 3c of the metal plate 3 and its vicinity.

As illustrated in FIG. 3, the outer peripheral surface 3c of the metal plate 3 includes a protruding portion 11 and a pair of recessed surfaces 12. The protruding portion 11 is disposed at a center portion of the metal plate 3 in a thickness direction and protrudes outward. A height of the protruding portion 11 is, for example, from 50 µm to 300 µm.

The recessed surface 12 has such a shape that the center portion of the surface is more recessed than at least a part of the peripheral portion of the surface. The pair of recessed surfaces 12 includes a recessed surface 12 at a side closer to the ceramic substrate 2 than the protruding portion 11 (hereinafter, also referred to as a recessed surface 12A) and a recessed surface 12 at a side farther from the ceramic substrate 2 than the protruding portion 11 (hereinafter, also referred to as a recessed surface 12B).

The recessed surface 12A is configured such that the bottom thereof is widened in a direction approaching the ceramic substrate 2 with the protruding portion 11 as a starting point. The recessed surface 12B is configured such that the bottom thereof is widened in a direction away from the ceramic substrate 2 with the protruding portion 11 as a starting point.

In the embodiment, providing the protruding portion 11 at the center portion of the outer peripheral surface 3c in the thickness direction causes electric field concentration to occur at the protruding portion 11 separated away from the ceramic substrate 2 at the metal plate 3 applied with a high voltage during an operation of the electronic device.

In the embodiment, providing the pair of the recessed surfaces 12 at both sides of the protruding portion 11 can increase a creepage distance.

That is, in the embodiment, even when a high voltage is applied during an operation of the electronic device, concentration of an electric field on the ceramic substrate 2 can be suppressed. Thus, dielectric breakdown of the ceramic substrate 2 can be suppressed. Thus, according to the embodiment, reliability of the electronic device on which the circuit board 1 is mounted can be improved.

In the embodiment, even when an ion migration phenomenon occurs at the protruding portion 11 due to the electric field concentration, a creepage distance to the outer peripheral surface 3c of the adjacent metal plate 3 can be extended by the recessed surface 12A positioned at the lower side. Thus, according to the embodiment, a short circuit between the metal plates 3 can be suppressed due to the ion migration phenomenon.

In the embodiment, the recessed surface 12A positioned at the lower side has a recessed shape, when the metal plate 3 is bonded by using the brazing material 5, creeping up of the brazing material 5 to the mounting surface 3a can be suppressed.

Thus, according to the embodiment, interference of the brazing material 5 that has crept up to the mounting surface 3a with electronic components can be suppressed, which allows the circuit board 1 to be easily mounted with the electronic components.

Note that the cross-section shape of the outer peripheral surface 3c as illustrated in FIG. 3 can be formed by substantially uniformly performing isotropic etching such as wet etching from both main surfaces of the metal plate 3 before bonding the metal plate 3 to the ceramic substrate 2.

That is, the circuit board 1 according to the embodiment may be formed by bonding the metal plate 3 formed in a predetermined circuit pattern by the isotropic etching to the front surface 2a of the ceramic substrate 2 with the brazing material 5.

In the embodiment, an outer peripheral surface 5a of the brazing material 5 may be disposed at the same position as that of a bottom portion 12Aa of the recessed surface 12A in a plan view. Thus, an end portion of the metal plate 3 can be suppressed to be a free end.

Thus, according to the embodiment, the stress concentration on the outer peripheral surface 5a of the brazing material 5 can be suppressed, which can improve mechanical reliability of the circuit board 1.

Note that in order to dispose the outer peripheral surface 3c of the brazing material 5 and the bottom portion 12Aa of the recessed surface 12A at the same position in a plan view, the same pattern as the circuit pattern of the metal plate 3 may be printed on the front surface 2a of the ceramic substrate 2 with the brazing material 5, and the metal plate 3 formed with the pattern may be positioned on the printed brazing material 5.

In the embodiment, in the brazing material 5 disposed between the metal plate 3 and the ceramic substrate 2, an amount of carbon and an amount of nitrogen in the outer peripheral portion may be larger than an amount of carbon and an amount of nitrogen in the center portion. Here, the outer peripheral portion of the brazing material 5 is, for example, a region within a range being equal to or less than 1 (mm) from the outer peripheral surface 5a of the brazing material 5, and the center portion of the brazing material 5 is a region positioned closer to the center than the outer peripheral portion of the brazing material 5.

In this way, increasing the amount of carbon and the amount of nitrogen in the outer peripheral portion of the brazing material 5 can reduce fluidity of the brazing material 5 positioned at the outer peripheral portion when the metal plate 3 is bonded by using the brazing material 5.

Thus, according to the embodiment, protrusion of the brazing material 5 to the recessed surface 12 can be suppressed, which can suppress creeping up of the brazing material 5 to the mounting surface 3a.

Reducing the amount of carbon and the amount of nitrogen in the center portion of the brazing material 5 can uniformly disperse the brazing material 5. Thus, according to the embodiment, thermal resistance of the brazing material 5 can be reduced, and thus, a heat dissipation property of the circuit board 1 can be enhanced. Uniformly dispersing the brazing material 5 can enhance adhesion strength between the brazing material 5, and the metal plate 3 and the ceramic substrate 2, so that reliability of the circuit board 1 can be increased.

Note that in the present disclosure, the amount of carbon and the amount of nitrogen in the brazing material 5 can be obtained by, for example, analyzing a cut surface of the brazing material 5 by using an electron probe microanalyzer (EPMA).

### First Variation

Various variations of the embodiment will be described with reference to FIG. 4 to FIG. 12. Note that, in the various variations below, portions that are the same as those in the embodiment will be denoted by the same reference signs, and redundant explanations may be omitted.

FIG. 4 is an enlarged cross-sectional view illustrating a configuration of the circuit board 1 according to a first variation of the embodiment. As illustrated in FIG. 4, in the first variation, the outer peripheral surface 5a of the brazing material 5 is disposed at an inner side from the outer peripheral surface 3c of the metal plate 3 (to be specific, the bottom portion 12Aa of the recessed surface 12A).

Thus, a distance between the protruding portion 11 and the brazing material 5 where electric field concentration occurs can be increased, so that the occurrence of the ion migration phenomenon caused by the brazing material 5 can be suppressed in the protruding portion 11. Consequently, according to the first variation, electrical reliability of the circuit board 1 can be improved.

Note that a distance between the outer peripheral surface 5a of the brazing material 5 and the outer peripheral surface 3c of the metal plate 3 may be, for example, equal to or less than 200 µm. This can achieve both the electrical reliability and the mechanical reliability of the circuit board 1.

### Second Variation

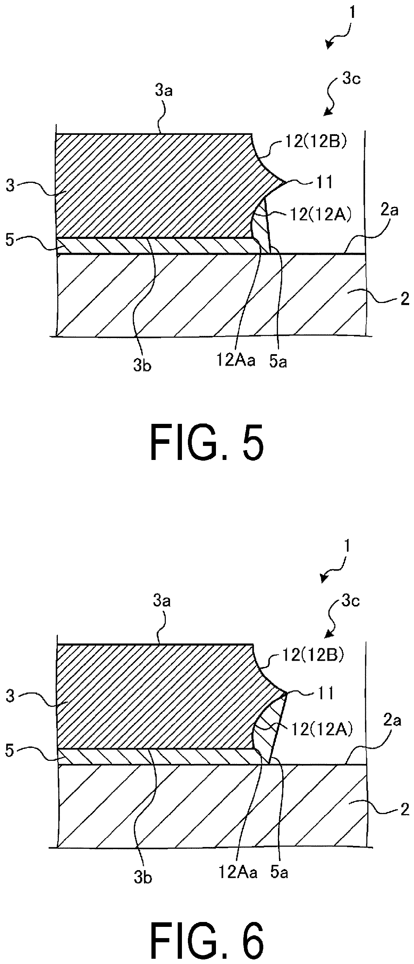

FIG. 5 is an enlarged cross-sectional view illustrating a configuration of the circuit board 1 according to a second variation of the embodiment. As illustrated in FIG. 4, in the second variation, the outer peripheral surface 5a of the brazing material 5 is disposed at an outer side of the bottom portion 12Aa of the recessed surface 12A in the outer peripheral surface 3c of the metal plate 3. In the second variation, the brazing material 5 is disposed protruding to the recessed surface 12A at the lower side.

Thus, in the metal plate 3, not only the bonding surface 3b but also the recessed surface 12A are in contact with the brazing material 5, so that an adhesion force of the metal plate 3 to the ceramic substrate 2 is increased. Consequently, according to the second variation, mechanical reliability of the circuit board 1 can be improved.

In the second variation, the amount of carbon and the amount of nitrogen in the brazing material 5 disposed protruding to the recessed surface 12A of the metal plate 3 may be larger than the amount of carbon and the amount of nitrogen in the brazing material 5 disposed between the metal plate 3 and the ceramic substrate 2.

In this way, increasing the amount of carbon and the amount of nitrogen in the brazing material 5 disposed protruding to the recessed surface 12A can reduce fluidity of the brazing material 5 protruding to the recessed surface 12A when the metal plate 3 is bonded with the brazing material 5.

Thus, according to the second variation, protrusion of the brazing material 5 to the recessed surface 12B can be suppressed, which can suppress creeping up of the brazing material 5 to the mounting surface 3a.

Reducing the amount of carbon and the amount of nitrogen in the brazing material 5 disposed between the metal plate 3 and the ceramic substrate 2 can uniformly disperse the brazing material 5. Thus, according to the second variation, thermal resistance of the brazing material 5 can be reduced, which can enhance a heat dissipation property of the circuit board 1. Uniformly dispersing the brazing material 5 can enhance adhesion strength between the brazing material 5, and the metal plate 3 and the ceramic substrate 2, so that reliability of the circuit board 1 can be increased.

### Third Variation

FIG. 6 is an enlarged cross-sectional view illustrating a configuration of the circuit board 1 according to a third variation of the embodiment. As illustrated in FIG. 6, in the third variation, the brazing material 5 disposed protruding to the recessed surface 12A is disposed in a manner that the brazing material on the protruding portion 11 side is further outside than the brazing material on the ceramic substrate 2 side.

This makes it possible to increase an adhesion force of the metal plate 3 to the ceramic substrate 2 while concentrating an electric field on the protruding portion 11 during an operation of the electronic device. Thus, according to the third variation, both the electrical reliability and the mechanical reliability of the circuit board 1 can be achieved.

### Fourth Variation

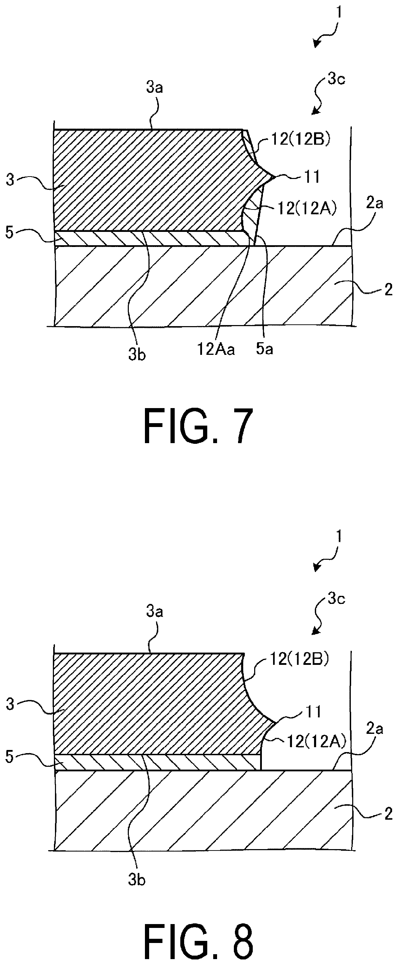

FIG. 7 is an enlarged cross-sectional view illustrating a configuration of the circuit board 1 according to the fourth variation of the embodiment. As illustrated in FIG. 7, in a fourth variation, the brazing material 5 is disposed protruding to both the recessed surface 12A at the lower side and the recessed surface 12B at the upper side.

Thus, in the metal plate 3, not only the bonding surface 3b but also the recessed surface 12A and the recessed surface 12B are in contact with the brazing material 5, so that an adhesion force of the metal plate 3 to the ceramic substrate 2 is further increased. Consequently, according to the fourth variation, mechanical reliability of the circuit board 1 can be improved.

In the fourth variation, as illustrated in FIG. 7, the brazing material 5 may be disposed such that the brazing material 5 does not adhere to a tip end portion of the protruding portion 11. This can suppress a decrease in the distance between the metal plates 3 adjacent to each other due to the brazing material 5 adhering to the tip end portion.

The brazing material 5 is not attached to the tip end portion of the protruding portion 11, which can suppress the occurrence of the ion migration phenomenon caused by the brazing material 5 in the protruding portion 11. Consequently, according to the fourth variation, electrical reliability of the circuit board 1 can be improved.

### Fifth Variation

FIG. 8 is an enlarged cross-sectional view illustrating a configuration of the circuit board 1 according to a fifth variation of the embodiment. As illustrated in FIG. 8, in the fifth variation, the protruding portion 11 is disposed closer to the ceramic substrate 2 side (the bonding surface 3b side) than the center portion of the metal plate 3 in the thickness direction. In the fifth variation, a radius of curvature of the recessed surface 12B at the upper side is larger than a radius of curvature of the recessed surface 12A at the lower side.

This makes it possible to reduce a residual stress generated at the end portion of the metal plate 3 when a temperature is lowered after the brazing process. This is because configuring the end portion of the metal plate 3 as illustrated in FIG. 8 causes a volume itself of the metal positioned at the end portion of the metal plate 3 to be reduced, and causes a residual stress generated in a vertically upward direction to be dispersed by the recessed surface 12A diagonally disposed.

Consequently, according to the fifth variation, mechanical reliability of the circuit board 1 can be improved. Note that the cross-section shape of the outer peripheral surface 3c as illustrated in FIG. 8 can be formed by etching the mounting surface 3a side more deeply than the bonding surface 3b side when isotropic etching is performed from both main surfaces of the metal plate 3.

### Sixth Variation

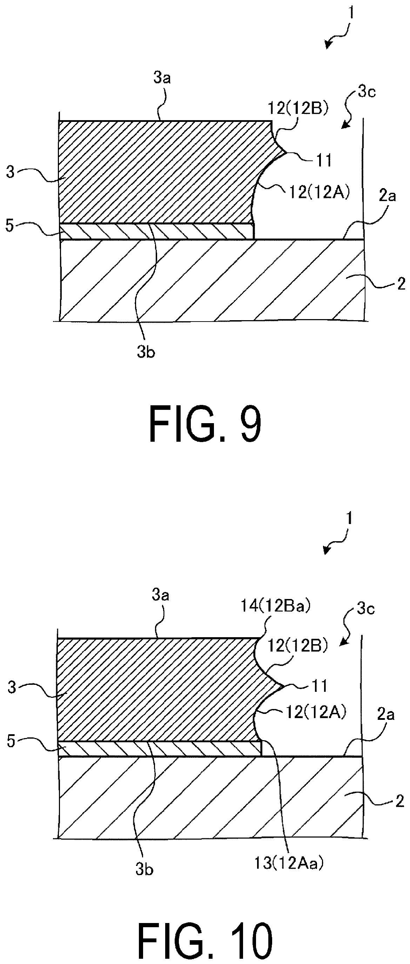

FIG. 9 is an enlarged cross-sectional view illustrating a configuration of the circuit board 1 according to a sixth variation of the embodiment. As illustrated in FIG. 9, in the sixth variation, the protruding portion 11 is disposed closer to the mounting surface 3a side than the center portion of the metal plate 3 in the thickness direction. In the fifth variation, a radius of curvature of the recessed surface 12A at the lower side is larger than a radius of curvature of the recessed surface 12B at the upper side.

As a result, in the metal plate 3 applied with a high voltage during an operation of the electronic device, electric field concentration can be generated at the protruding portion 11 that is further away from the ceramic substrate 2, so that dielectric breakdown of the ceramic substrate 2 can be further suppressed.

In the sixth variation, creeping up of the brazing material 5 to the tip end portion of the protruding portion 11 can be suppressed, which allows the occurrence of the ion migration phenomenon caused by the brazing material 5 to be suppressed in the protruding portion 11.

Consequently, according to the sixth variation, electrical reliability of the circuit board 1 can be improved.

### Seventh Variation

FIG. 10 is an enlarged cross-sectional view illustrating a configuration of the circuit board 1 according to a seventh variation of the embodiment. As illustrated in FIG. 10, in the seventh variation, the outer peripheral surface 3c of the metal plate 3 includes different protruding portions 13 and 14. The protruding portion 13 is positioned at a side closer to the ceramic substrate 2 than the protruding portion 11, and the protruding portion 14 is positioned at a side farther from the ceramic substrate 2 than the protruding portion 11.

The different protruding portion 13 is provided at the bottom portion 12Aa of the recessed surface 12A, and the different protruding portion 14 is provided at a bottom portion 12Ba of the recessed surface 12B.

Thus, when not only the bonding surface 3b but also the recessed surface 12A of the metal plate 3 are in contact with the brazing material 5, a contact area between the recessed surface 12A and the brazing material 5 can be further increased. Thus, according to the seventh variation, an adhesion force of the metal plate 3 to the ceramic substrate 2 is further increased, which can further improve mechanical reliability of the circuit board 1.

In the seventh variation, the recessed surface 12A has a recessed shape with a large curvature, when the metal plate 3 is bonded with the brazing material 5, creeping up of the brazing material 5 to the tip end portion of the protruding portion 11 can be further suppressed.

As a result, according to the seventh variation, the occurrence of the ion migration phenomenon caused by the brazing material 5 can be further suppressed in the protruding portion 11.

### Eighth Variation

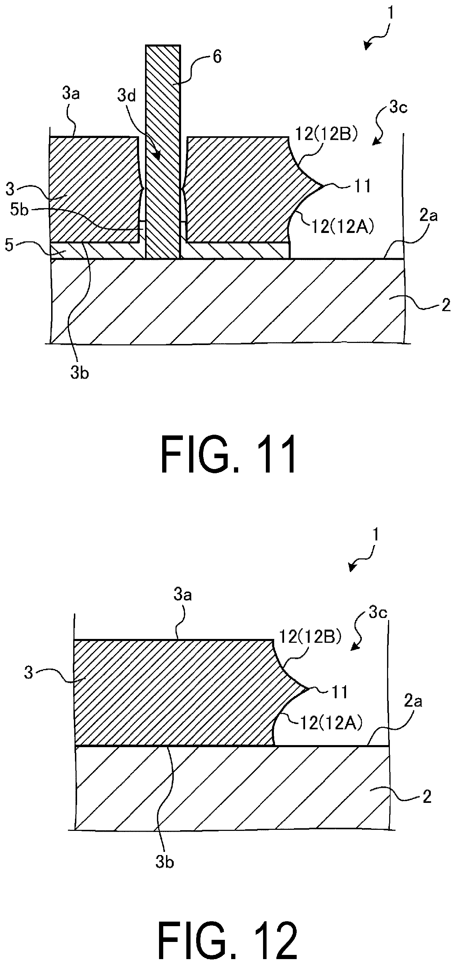

FIG. 11 is an enlarged cross-sectional view illustrating a configuration of the circuit board 1 according to an eighth variation of the embodiment. As illustrated in FIG. 11, the eighth variation is different from the embodiment in a point that a metal pin 6 is erected through the metal plate 3. To be specific, a through hole 3d is formed at a predetermined position of the metal plate 3, and the metal pin 6 is inserted into the through hole 3d, so that the metal pin 6 is erected through the metal plate 3.

As metal constituting the metal pin 6, for example, metal containing copper, silver, aluminum, an alloy of these metals, or the like as a main component is suitably used. The metal pin 6 preferably contains copper that is the same material as that of the metal plate as a main component from the viewpoint of achieving the same linear expansion coefficient.

Here, in the eighth variation, the metal pin 6 may be fixed to the metal plate 3 by using the brazing material 5. Thus, the metal pin 6 and the metal plate 3 can be electrically connected to each other through the brazing material 5.

In the eighth variation, electrical resistance between the metal pin 6 and the metal plate 3 can be reduced as compared with the case where the metal plate 3 and the metal pin 6 are electrically connected to each other by fitting the metal pin 6 to the metal plate 3.

Thus, according to the eighth variation, damage to the periphery of the metal pin 6 can be suppressed when a large current flows through the electronic component, which allows an allowable current that can flow through the electronic component mounted on the circuit board 1 to be increased.

Compared to a case where the metal pin 6 is fixed by using a solder material instead of the brazing material 5, in the eighth variation, melting and damaging of the bonding portion of the metal pin 6 can be suppressed when the electronic device is used in a high-temperature environment. This is because the brazing material 5 has a higher melting point than that of the solder material.

When the metal pin 6 is fixed by using the solder material instead of the brazing material 5, a process of soldering the metal pin 6 is additionally required. On the other hand, in the eighth variation, the metal plate 3 and the metal pin 6 can be collectively fixed by using the brazing material 5, the manufacturing process of the circuit board 1 can be simplified.

Thus, according to the eighth variation, thermal resistance of the circuit board 1 can be improved, and a manufacturing cost of the circuit board 1 can be reduced.

In the eighth variation, as illustrated in FIG. 11, the metal pin 6 may be in contact with the brazing material 5 not only at the portion protruding downward from the metal plate 3 but also in the through hole 3d of the metal plate 3. That is, in the eighth variation, the brazing material 5 may include a creep-up portion 5b that creeps up a gap between the metal plate 3 and the metal pin 6 in the through hole 3d.

Thus, a contact area between the metal pin 6 and the brazing material 5 can be increased, which allows electrical resistance between the metal pin 6 and the metal plate 3 to be further reduced. Thus, according to the eighth variation, an allowable current that can flow through the electronic component mounted on the circuit board 1 can be further increased.

The creep-up portion 5b can be formed by inserting the metal pin 6 so as to press the brazing material 5 from above upon inserting the metal pin 6 into the through hole 3d after placing the metal plate 3 on the brazing material 5 printed on the ceramic substrate 2.

In the eighth variation, the through hole 3d of the metal plate 3 can be formed by substantially uniformly performing isotropic etching from both main surfaces of the metal plate 3 when the metal plate 3 is formed into a predetermined circuit pattern.

### Ninth Variation

FIG. 12 is an enlarged cross-sectional view illustrating a configuration of the circuit board 1 according to a ninth variation of the embodiment. Although the metal plate 3 is bonded to the ceramic substrate 2 by using the brazing material 5 in the embodiment and the various variations that have been described above, the metal plate 3 may be directly bonded to the ceramic substrate 2 as illustrated in FIG. 12.

In the ninth variation, for example, the metal plate 3 containing copper as a main component is directly bonded to the front surface 2a of the ceramic substrate 2 by using a eutectic phase such as Cu-Cu₂O. The metal plate 3 containing aluminum as a main component may be directly bonded to the front surface 2a of the ceramic substrate 2 containing silicon nitride as a main component by using an Al-Si eutectic phase.

Also in the ninth variation, similar to the embodiment, the protruding portion 11 is provided at the center portion of the outer peripheral surface 3c in the thickness direction. Thus, in the metal plate 3 applied with a high voltage during an operation of the electronic device, electric field concentration can be generated at the protruding portion 11 separated from the ceramic substrate 2.

In the ninth variation, providing the pair of recessed surfaces 12 at both sides of the protruding portion 11 can increase a creepage distance.

That is, in the ninth variation, even when a high voltage is applied during an operation of the electronic device, concentration of an electric field at the ceramic substrate 2 can be suppressed, which can suppress dielectric breakdown of the ceramic substrate 2. Thus, according to the ninth variation, reliability of the electronic device in which the circuit board 1 is mounted can be improved.

### Manufacturing Process for Circuit Board

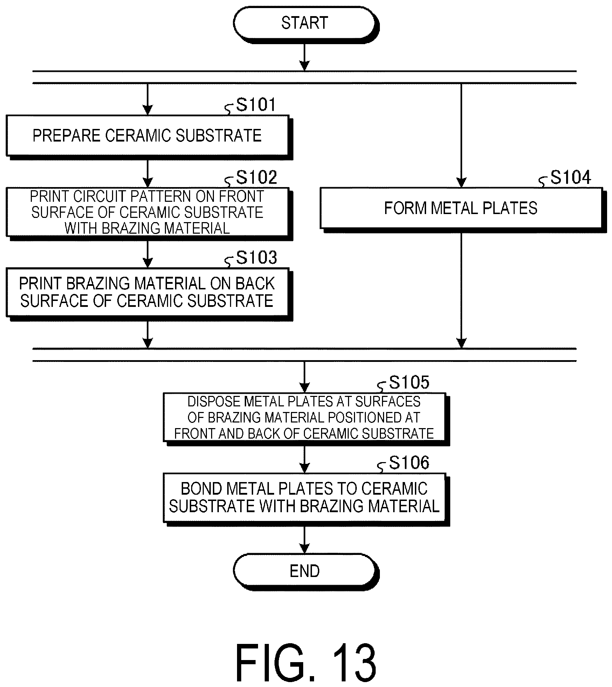

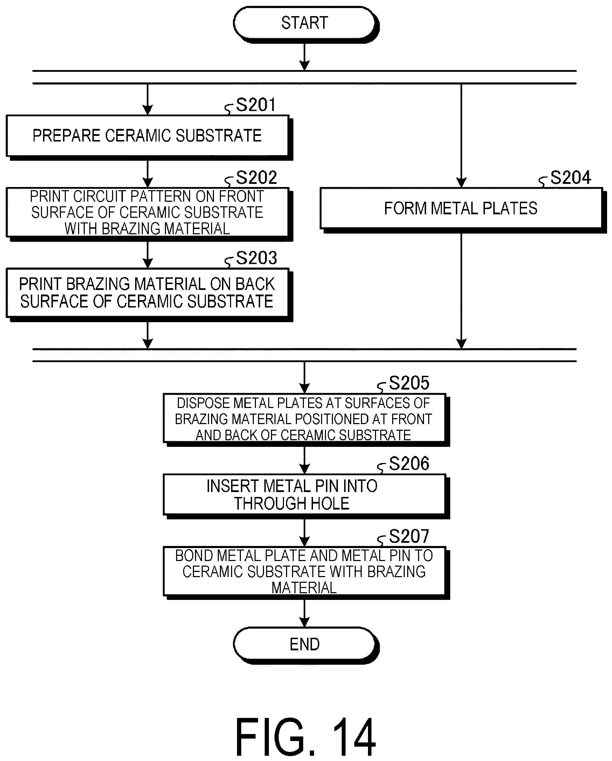

A manufacturing process for the circuit board 1 according to the embodiment and the eighth variation will be described with reference to FIG. 13 and FIG. 14. FIG. 13 is a flowchart illustrating a procedure of a manufacturing process for the circuit board 1 according to the embodiment.

As illustrated in FIG. 13, in the manufacturing process, first, the ceramic substrate 2 having a flat plate shape is prepared (Step S101). Note that, in Step S101, blank baking of the ceramic substrate 2 or the like is performed as necessary.

A predetermined circuit pattern is printed on the front surface 2a of the prepared ceramic substrate 2 with the brazing material 5 containing active metal (Step S102). The brazing material 5 containing the active metal is printed in a substantially rectangular shape on the back surface 2b of the ceramic substrate 2 (Step S103).

Note that processing in Step S103 may be performed prior to processing in Step S102, or may be simultaneously performed with processing in Step S102.

In parallel with the processing of the above-described Steps S101 to S103, in the present manufacturing process, the metal plate 3 is formed by shaping a metal plate serving as a raw material into a predetermined circuit pattern by isotropic etching from both surfaces, and the metal plate 4 is formed by shaping a metal plate serving as a raw material into a rectangular shape (Step S104).

In the embodiment, the protruding portion 11 and the pair of recessed surfaces 12 are formed at the outer peripheral surface 3c of the metal plate 3 in the processing of Step S104.

The metal plates 3 and the metal plate 4 are disposed on the surfaces of the brazing material 5 printed on the front surface 2a and the back surface 2b of the ceramic substrate 2, respectively (Step S105). In the processing of Step S105, the metal plates 3 and the metal plate 4 are disposed on the surfaces of the brazing material 5 while the printed shapes of the brazing material 5 and the shapes of the metal plates 3 and the metal plate 4 are positioned so as to overlap each other.

The brazing material 5 is heated to a melting temperature or higher and melted, which bonds the metal plates 3 and the metal plate 4 that are disposed on the surfaces of the brazing material 5 to the front surface 2a and the back surface 2b of the ceramic substrate 2 with the brazing material 5 (Step S106).

Note that in the manufacturing method according to the present disclosure, an etching process of the brazing material does not need to be additionally performed. Thus, the process can be simplified and a decrease in electrical reliability can be suppressed due to a residue of the etched brazing material.

In the embodiment, the brazing material 5 may be heated in a vacuum or an inert atmosphere such as nitrogen gas or argon gas in the processing of Step S106. This allows the brazing material 5 positioned at the outer peripheral portion (or protruding to the recessed surface 12A) to be more exposed to carbon and nitrogen in the atmosphere than the brazing material 5 positioned at the center portion (or disposed between the metal plate 3 and the ceramic substrate 2).

Thus, according to the embodiment, an amount of carbon and an amount of nitrogen in the brazing material 5 positioned at the outer peripheral portion (or protruding to the recessed surface 12A) can be made larger than an amount of carbon and an amount of nitrogen in the brazing material 5 positioned at the center portion (or disposed between the metal plate 3 and the ceramic substrate 2).

The ceramic substrate 2 bonded with the metal plate 3 and the metal plate 4 is subjected to a laser beam machining process, a chemical polishing process, a rust proofing process, or the like as necessary to complete the manufacturing process of the circuit board 1 according to the embodiment.

FIG. 14 is a flowchart illustrating a procedure of a manufacturing process for the circuit board 1 according to the eighth variation of the embodiment. As illustrated in FIG. 14, in the manufacturing process, first, the ceramic substrate 2 having a flat plate shape is prepared (Step S201).

A predetermined circuit pattern is printed on the front surface 2a of the prepared ceramic substrate 2 with the brazing material 5 containing active metal (Step S202). The brazing material 5 containing the active metal is printed in a substantially rectangular shape on the back surface 2b of the ceramic substrate 2 (Step S203).

In parallel with the processing of the above-described Steps S201 to S203, in the present manufacturing process, the metal plate 3 is formed by shaping a metal plate serving as a raw material into a predetermined circuit pattern by isotropic etching from both surfaces, and the metal plate 4 is formed by shaping a metal plate serving as a raw material into a rectangular shape (Step S204).

Note that in the eighth variation, in the processing of Step S104, the protruding portion 11 and the pair of recessed surfaces 12 are formed at the outer peripheral surface 3c of the metal plate 3, and the through hole 3d through which the metal pin 6 is inserted is formed.

The metal plates 3 and the metal plate 4 are disposed on the surfaces of the brazing material 5 printed on the front surface 2a and the back surface 2b of the ceramic substrate 2, respectively (Step S205). In the processing of Step S205, the metal plates 3 and the metal plate 4 are disposed on the surfaces of the brazing material 5 while the printed shapes of the brazing material 5 and the shapes of the metal plates 3 and the metal plate 4 are positioned so as to overlap each other.

The metal pin 6 is inserted into the through hole 3d formed in the metal plate 3 (Step S206). In the processing of the Step S206, the creep-up portion 5b in the brazing material 5 may be preferably formed by inserting the metal pin 6 so as to press the brazing material 5 from above.

The brazing material 5 is heated to a melting temperature or higher and melted, so that the metal plates 3, the metal plate 4, and the metal pin 6 that are disposed on the surfaces of the brazing material 5 are bonded to the front surface 2a and the back surface 2b of the ceramic substrate 2 with the brazing material 5 (Step S207).

The ceramic substrate 2 bonded with the metal plates 3, the metal plate 4, and the metal pin 6 is subjected to a laser beam machining process, a chemical polishing process, a rust proofing process, or the like as necessary to complete the manufacturing process of the circuit board 1 according to the eighth variation.

The embodiment according to the present invention has been described above. However, the present invention is not limited to the embodiment described above, and various modifications can be made without departing from the essential spirit of the present invention. For example, in the above-described embodiment, the ceramic substrate 2 and the metal plates 3 and 4 are layered to form the circuit board 1, but the metal plate 4 at the back surface side may be omitted.

Additional effects and other aspects can be easily derived by a person skilled in the art. Thus, a wide variety of aspects of the present invention are not limited to the specific details and representative embodiments represented and described above. Accordingly, various changes are possible without departing from the spirit or scope of the general inventive concepts defined by the appended claims and their equivalents.

### REFERENCE SIGNS

1 Circuit board
2 Ceramic substrate
2a Front surface (an example of one main surface)
3 Metal plate
3c Outer peripheral surface
3d Through hole
5 Brazing material
5a Outer peripheral surface
6 Metal pin
11 Protruding portion
12, 12A, 12B Recessed surface
13, 14 Different protruding portion

## Claims

1. A circuit board, comprising:
a ceramic substrate having a flat plate shape; and
a metal plate bonded to one main surface of the ceramic substrate, the metal plate comprising a predetermined circuit pattern, wherein
an outer peripheral surface of the metal plate comprises a protruding portion protruding outward and a pair of recessed surfaces provided at both sides of the protruding portion.

2. The circuit board according to claim 1, wherein
the protruding portion is disposed away from the one main surface of the ceramic substrate.

3. The circuit board according to claim 2, wherein
the protruding portion is disposed at a center portion of the metal plate in a thickness direction.

4. The circuit board according to claim 2, wherein
the protruding portion is disposed closer to a side of the ceramic substrate than a center portion of the metal plate in a thickness direction.

5. The circuit board according to any one of claims 1 to 4, wherein
the outer peripheral surface of the metal plate comprises different protruding portions, one of the different protruding portions is positioned at a side closer to the ceramic substrate than the protruding portion, and the other of the different protruding portions is positioned at a side farther from the ceramic substrate than the protruding portion.

6. The circuit board according to any one of claims 1 to 5, wherein
the ceramic substrate and the metal plate are bonded with a brazing material comprising active metal.

7. The circuit board according to claim 6, wherein
an outer peripheral surface of the brazing material is disposed at an inner side from the outer peripheral surface of the metal plate.

8. The circuit board according to claim 6 or 7, wherein
in the brazing material disposed between the ceramic substrate and the metal plate, an amount of carbon and an amount of nitrogen in an outer peripheral portion are larger than an amount of carbon and an amount of nitrogen in a center portion.

9. The circuit board according to claim 6, wherein
the brazing material is disposed protruding to the recessed surface at a side close to the ceramic substrate.

10. The circuit board according to claim 9, wherein
the brazing material disposed protruding to the recessed surface is disposed in a manner that the brazing material on a side of the protruding portion is further outside than the brazing material on a side of the ceramic substrate.

11. The circuit board according to claim 6, wherein
the brazing material is disposed protruding to the recessed surface at a side close to the ceramic substrate and the recessed surface at a side far from the ceramic substrate.

12. The circuit board according to any one of claims 9 to 11, wherein
an amount of carbon and an amount of nitrogen in the brazing material disposed protruding to the recessed surfaces are larger than an amount of carbon and an amount of nitrogen in the brazing material disposed between the ceramic substrate and the metal plate.

13. The circuit board according to any one of claims 6 to 12, further comprising:
a metal pin inserted into a through hole formed in the metal plate, wherein
the metal pin is fixed with the brazing material.

14. A manufacturing method for a circuit board, comprising:
printing a predetermined circuit pattern on one main surface of a ceramic substrate having a flat plate shape by using a brazing material comprising active metal;
disposing a metal plate patterned into a predetermined circuit pattern on a surface of the brazing material printed; and
bonding the metal plate to the one main surface of the ceramic substrate with the brazing material, wherein
an outer peripheral surface of the metal plate comprises a protruding portion protruding outward and a pair of recessed surfaces provided at both sides of the protruding portion.
